# EUROPÄISCHE PATENTSCHRIFT

(11) **EP 1 431 765 B1**
(45) Veröffentlichungstag und Bekanntmachung des Hinweises auf die Patenterteilung: **26.01.2011**
(21) Anmeldenummer: 03028854.2
(22) Anmeldetag: 16.12.2003
(51) Int. Cl.: G01R 11/04

(54) **Vorrichtung zur Ankopplung eines Stromzählers an eine Trägerplattform**
Apparatus for coupling an electric energy meter to a support platform
Dispositif de couplage d'un compteur d'électricité à une plate-forme de support

(30) Priorität: 20.12.2002 DE 10261206; 16.05.2003 DE 10323160
(43) Veröffentlichungstag der Anmeldung: 23.06.2004
(60) Teilanmeldung: 10011479.2
(73) Patentinhaber: Hager Electro GmbH & Co. KG, 66440 Blieskastel (DE)
(72) Erfinder: Clemens, Guntram, Dr.-Ing., 90409 Nürnberg (DE); Kelaiditis, Konstantin, Dr.-Ing., 66386 St. Ingbert (DE); Zimmermann, Manfred, 66131 Saarbrücken (DE); Zimmermann, Michael, 66399 Mandelbachtal (DE)
(74) Vertreter: Bernhardt, Winfrid

(56) Entgegenhaltungen:
- DE-A- 10 052 998
- DE-A- 10 054 771
- DE-U- 9 108 297
- DE-U- 9 201 552

## Beschreibung

Die Erfindung betrifft eine Vorrichtung für den Anschluss eines elektronischen Stromzählers gemäß Oberbegriff des Anspruchs 1.

Zum Beispiel in Wohnhäusern installierte Stromzähler sind in einem Zählerkasten untergebracht, an dessen eine Trägerplattform bzw. Zahlertragplatte bildenden Boden der Stromzähler mechanisch befestigt ist und in welchen die an den Zähler anzuschließenden Stromleitungen hineingeführt sind. Bekanntermaßen erfolgt die Befestigung des Stromzählers mit Hilfe des sogenannten Zählerkreuzes, das durch einen vertikalen und horizontalen Befestigungsschenkel gebildet ist, wobei die Befestigungsschenkel am Boden des Zählerkastens angebracht sind.

In zunehmendem Maße werden die herkömmlichen elektromechanischen Stromzähler durch elektronische Zähler ersetzt. Parallel dazu strebt man an, die Installation und Auswechslung von Stromzöhlem an den Zählerplätzen zu vereinfachen.

Die DE 100 52 998 A 1 beschreibt eine zur Aufnahme eines elektronischen Stromzählers vorgesehene Trägerplattform, an welcher der Stromzähler ohne Verwendung eines Werkzeugs über eine Schnellkupplung ankoppelbar ist, wobei mit der Ankopplung automatisch eine Verbindung mit zum Zähler führenden und vom Zähler wegführenden Stromleitungen erfolgt. Der Stromzähler weist auf seiner der Trägerplattform zugewandten Seite vorstehende Kontaktstifte auf, welche in Öffnungen in der Trägerplattform eingreifen und in Kontakt mit in der Trägerplattform vorgesehenen Federkontaktelementen kommen. Durch Verschiebung auf der Plattform lässt sich der Stromzähler in eine Verriegelungsposition bringen, in welcher er durch Formschluss mechanisch mit der Plattform verbunden ist.

Der Adapter der DE-U-9108297 weist auf seiner dem elektronischen Stromzähler zugewandten Seite eine von einem Trägerboden vorstehende Befestigungsschiene auf, welche in einer entsprechenden Ausnehmung im Gehäuse des Stromzählers zur Anordnung kommt. In seitliche Öffnungen an der Trägerschiene greift ein mit dem Stromzählergehäuse verbundener Riegel ein. Zu zählenden Strom zuführende Stromleiter sind durch eine ausbrechbare Öffnung im Trägerboden hindurch direkt zu einer Anschlussleiste am Stromzähler geführt.

Der Erfindung liegt die Aufgabe zugrunde, eine neue Anschlussvorrichtung der im Oberbegriff des Anspruchs 1 angegebenen Art zu schaffen, bei welcher eine elektrische Ankopplung des Stromzählers an die Trägerplattform erleichtert ist.

Diese Aufgabe wird durch die in Anspruch 1 angegebenen Merkmale gelöst. Allein durch die Arretierung und Plombierung des Stromzählers oder der Abdeckhaube sind damit beide Teile gesichert. Durch einen einzigen, wenigstens eines der beiden Teile gegen Verschiebung parallel zur Zählertragplatte sichernden, Bolzen können beide Teile an Ort und Stelle gehalten werden.
Zweckmäßig lässt sich der Stromzähler an dem Adapter unter automatischer Verbindung mit den Stromleitern ohne Werkzeugeinsatz über eine Schnellkupplung, vorzugsweise durch Formschluss, befestigen.

Die Stromleiter weisen z.B. Federkontaktelemente mit einer gegen einen Überbrückungsleiter anliegenden Kontaktnase auf, wobei die Kontaktnase durch ein vom Gehäuse des Stromzählers vorstehendes Kontaktelement bei der Ankopplung des Stromzählers an den Adapter von dem Überbrückungsleiter trennbar ist. Im nicht gekoppelten Zustand ist der zum Zähler führende Leiter und mit dem vom Zähler wegführende Stromleiter durch den Überbrückungsleiter kurzgeschlossen.

Vorteilhaft ist in einer ersten Kopplungsphase, während die vom Zählergehäuse vorstehenden Kontakte schon elektrisch mit den Federkontaktelementen verbunden sind, die Überbrückung noch nicht aufgehoben. In dieser Phase kann die Funktion des Zählers überprüft werden, bevor er in die Endstellung gebracht wird, in welcher die Kontaktnasen vom Überbrückungsleiter getrennt sind. So lässt sich z.B. verhindern, dass durch Ankopplung eines defekten Zählers der Stromfluss unterbrochen wird.

In weiterer Ausgestaltung der Erfindung können an dem Adapter Einrichtungen zur Anbringung weiterer Geräte angebracht sein, z.B. mit dem Stromzähler verbundene Steuergeräte, die zeitabhängig den Stromtarif ändern. So lässt z.B. der den Stromzähler aufnehmende Zwischenboden über die vom Stromzähler eingenommenen Fläche hinaus erweitern und sich über dem erweiterten Zwischenboden eine Hutschiene anordnen.

In einer weiteren Ausführungsform, die in bezug auf die Manipulationssicherheit weiter verbessert ist, sind Einrichtungen zur Lösung der Verbindung des Adapters mit der Zählertragplatte der Trögerplattform durch den an den Adapter angekoppelten Stromzähler blockiert.

Der durch plombierbare Einrichtungen in der Ankopplungsposition arretierte Stromzähler verhindert die Betätigung der betreffenden Einrichtungen, so dass der Adapter von der Zählertragplatte nicht lösbar ist und Manipulationen durch Unbefugte an der Stromzählereinrichtung ausgeschlossen sind.

Bei den Einrichtungen zur Lösung der Verbindung von Adapter und Zählertragplatte kann es sich z.B. um einen Kopf eines Verbindungselements, z.B. einer Schraube oder eines Bolzens, handeln, welcher durch den angekoppelten Stromzähler abgedeckt und dadurch unzugänglich ist.

Vorzugsweise sind zur Verbindung des Adapters mit der Zählertragplatte Hakenelemente auf der der Zählertragplatte zugewandten Seite des Adapters gebildet, wobei wenigstens eines der Hakenelemente im Schlitz einer Halteschiene eines Zählerkreuzes einhakbar sein kann.

Insbesondere ist wenigstens eines der Hakenelemente im Zuge einer Kippbewegung des Adapters in ein, vorzugsweise durch eine der Halteschienen des Zählerkreuzes gebildetes, Hakenwiderlager einhängbar. Vorzugsweise ist das betreffende Hakenelement am Rand einer der Zählertragplatte zugewandten Seitenfläche des Adapters angeordnet und weist einen sich parallel zu der Fläche zu dem Rand hin erstreckenden Hakenschenkel auf. Vorzugsweise steht dieser Hakenschenkel über den Rand hinaus vor. Die Kippbewegung erlaubt es, die Abmessungen des Hakenelements in bezug auf die Schlitzbreite so zu wählen, dass eine verbleibende Verschiebungsmöglichkeit parallel zur Zählertragplatte kleiner ist als die Länge des betreffenden Hakenschenkels, so dass der Adapter durch Parallelverschiebungen zur Zählertragplatte nicht in eine Stellung gelangen kann, in welcher er sich von der Tragplatte abheben lässt. Vorzugsweise sind zwei Hakenelemente im Schlitz der horizontalen Halteschiene des Zählerkreuzes eingehängt, während ein weiteres Hakenelement an einem den obengenannten Drehknopf aufweisenden Drehbolzen gebildet ist. Dieses Hakenelement greift in den Schlitz der vertikalen Halteschiene des Zählerkreuzes ein.

Die Erfindung soll nun anhand von Ausführungsbeispielen und der beiliegenden, sich auf diese Ausführungsbeispiele beziehenden Zeichnungen näher erläutert werden. Es zeigen:
- Fig. 1: eine Adaptervorrichtung in einer perspektivischen An- sicht,
- Fig. 2: die Vorrichtung von Fig. 1 in einer teilweise geschnittenen Draufsicht,
- Fig. 3: eine Längsschnittansicht der Vorrichtung von Fig. 1,
- Fig. 4: eine Querschnittsansicht der Vorrichtung von Fig. 1,
- Fig. 5: einen Vertikalschnift durch einen Zählerkasten, in welchen die Vorrichtung von Fig. 1 eingebaut ist,
- Fig. 6: einen Horizontalquerschnitt des Zählerkastens von Fig. 5,
- Fig. 7: ein zweites Beispiel für eine Adaptervorrichtung,
- Fig. 8: einen Stromzähleradapter in einer perspektivischen An- sicht,
- Fig. 9: den Stromzähleradapter von Fig. 1 in einer Rückansicht,
- Fig. 10: eine teilweise geschnittene Seitenansicht des Stromzähleradapters von Fig. 1, wobei der Adapter auf einer Zählertragplatte montiert ist,
- Fig. 11: eine die Befestigung des Zähleradapters von Fig. 1 an einer Zählertragplatte erläuternde Darstellung,
- Fig. 12: eine teilweise geschnittene Seitenansicht des Stromzähleradapters von Fig. 1 mit einer Leistenabdeckhaube, die sich am Adapter formschlüssig durch einen daran angekoppelten Stromzähler halten lässt,
- Fig. 13a und b: weitere Stromzähleradapter mit Leistenabdeckhauben, und
- Fig. 14: ein weiteres Ausführungsbeispiel für eine Hakenbefestigung.

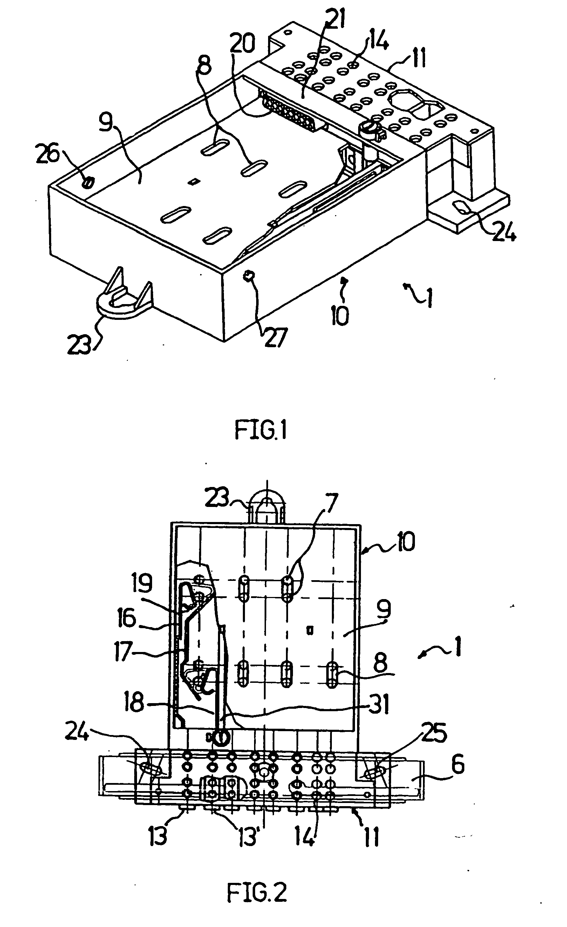

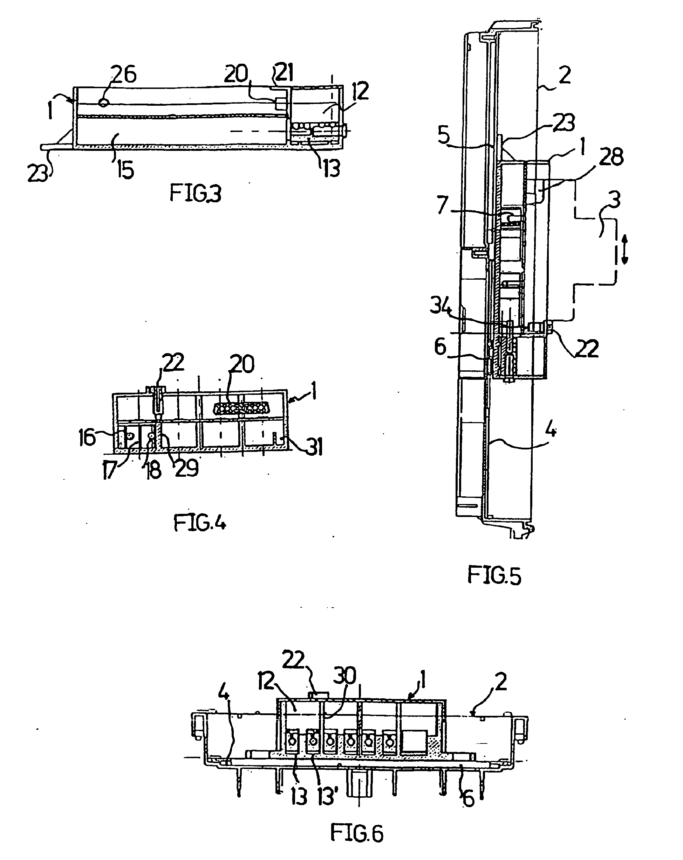

Ein in Fig. 1 bis 4 gezeigter Adapter 1 ist zum Einbau in einen Zählerkasten 2 (Fig. 5) vorgesehen. Über den Adapter 1 lässt sich in dem Zählerkasten 2 ein Stromzähler 3 installieren. In dem betreffenden Beispiel handelt es sich um einen elektronischen Stromzähler, dessen Gestaltung eine unmittelbare Verbindung mit dem Zählerkasten 2 nicht zulässt.

Wie Fig. 5 erkennen lässt, weist der elektronische Stromzähler 3 in Richtung zum Boden 4 des Zählerkastens vorstehende Kontaktstifte 7 auf. In dem betreffenden Beispiel sind sieben Kontaktstifte entsprechend drei Stromphasen und einem dem elektronischen Stromzähler 3 zuzuführenden Nullleiter vorgesehen. Die Kontaktstifte 7 greifen in Langlöcher 8 ein, welche in einem Zwischenboden 9 eines kastenartigen Teils 10 des Adapters 1 gebildet sind.

An einer Schmalseite des einseitig offenen Kastenteils 10 ist eine Anschlussleiste 11 angebracht.

In elektrisch gegeneinander durch Trennwände 30 isolierten Kammern 12 der Anschlussleiste 11 sind jeweils Schraubklemmanschlusselemente 13 und 13' entsprechend einem zum Stromzähler führenden und vom Stromzähler wegführenden Stromleiter gebildet. Die Schrauben der Schraubklemmanschlusselemente 13,13' sind durch Wandöffnungen 14 in der Anschlussleiste 11 für einen Schraubendreher zugänglich.

Unter dem Zwischenboden 9 des Kastenteils 10 befinden sich durch Zwischenwände 29 getrennte Kammern 15. Wie insbesondere aus Fig. 2 hervorgeht, sind in jeder Kammer 15 Federkontaktelemente 16 und 18 sowie ein Überbrückungsleiter 17 untergebracht, wobei für jede der drei Stromphasen ein solcher, durch gebogene Blechstreifen gebildeter Satz aus Federkontaktelementen und einem Überbrückungsleiter vorgesehen ist.

Die Federkontaktelemente 16 und 18 sind jeweils mit einem der Schraubklemmanschlusselemente 13 bzw. 13' verbunden. Solange der elektronische Zähler 3 nicht an den Adapter 1 gekoppelt ist, stehen die Federkontaktelemente 16 und 18 jeweils über eine elastisch abbiegbare Kontaktnase 19 in elektrischer Verbindung mit dem Überbrückungsleiter 17, d.h. die Schraubklemmanschlusselemente 13,13' sind kurzgeschlossen.

Das Bezugszeichen 20 bezeichnet ein Steckverbindungselement, über welches sich der Stromzähler 3, der ein entsprechendes Gegenstück aufweist (nicht gezeigt), mit Signalkabeln verbinden lässt. Das Steckanschlusselement 20 ist unterhalb eines sich im Abstand vom Zwischenboden 9 über dem Zwischenboden erstreckenden Wandteils 21 gebildet, welcher eine Öffnung für ein Steckschloss 22 aufweist. Durch den Wandteil 21 ist eine Tasche für die Aufnahme eines vorspringenden Abschnitts 34 des Zählergehäuses gebildet. Der Abschnitt 34 weist einen das Steckschloss 22 aufnehmenden Kanal auf.

An der der Anschlussleiste 11 gegenüberliegenden Seite des Adapters 1 ist eine Anschlusslasche z.B. zur Schraubbefestigung des Adapters am Schenkel 5 des Zählerkreuzes vorgesehen. Laschen 24 und 25 zur Schraubbefestigung am Schenkel 6 des Zählerkreuzes sind an den Längsenden der Anschlussleiste 11 gebildet.

Innerhalb des Kastenteils 10 sind an den Längswänden einander gegenüberliegend Nasen 26 und 27 für den Eingriff in Nuten 28 am Gehäuse des elektronischen Stromzählers 3 (Fig. 5) vorgesehen. Die Nuten 28 weisen zueinander im Winkel von 90° stehende Abschnitte auf.

Der Adapter 1 lässt sich auf dem Boden 4 des Zählerkastens 2, der eine Aufnahmeplattform für einen mittels Zählerkreuz zu befestigenden Stromzähler bildet, mit Hilfe der Schenkel 5 und 6 des Zählerkreuzes befestigen und über die Klemmanschlusselemente 13,13' mit in den Zählerkasten geführten Stromkabeln verbinden, die ihrerseits an einer im Zählerkasten 2 angebrachten Anschlussleiste (nicht gezeigt) enden können. Der Zählerkasten 2 mit dem darin eingebauten Adapter 1 ist damit in der Lage, den elektronischen Zähler 3 aufzunehmen.

Zur Ankopplung wird der elektronische Zähler 3 auf den Zwischenboden 9 aufgesetzt, wobei die von der Bodenfläche des Stromzählers 3 vorstehenden Kontaktstifte 7 durch die Langlöcher 8 hindurch in die Kammern 15 unter dem Zwischenboden 9 eingeführt werden. In der Position, in welcher der Stromzähler 3 auf den Zwischenboden 9 aufsetzbar ist, haben die Kontaktstifte noch keinen Kontakt zu den Federkontaktelementen 16 und 18 in den Kammern 15.

Der elektronische Stromzähler 3 lässt sich parallel zu dem Zwischenboden 9 verschieben, wobei der vorstehende Abschnitt 34 des Stromzählergehäuses in die Tasche unter den Wandteil 21 des Kastenteils 10 gelangt. Das am Zählergehäuse vorgesehene Steckverbindungsgegenstück greift dabei in das Steckverbindungselement 20 ein. Die Nasen 26 und 27 verschieben sich in einem Teil der Nuten 28 am Zählergehäuse, welcher sich parallel zum Zwischenboden 9 erstreckt. Der Stromzähler 3 ist damit formschlüssig an dem Zwischenboden gehalten.

Mit der Verschiebung des Stromzählers 3 kommen die Kontaktstifte 7 in Berührung mit den Kontaktnasen 19 der Federkontaktelemente 16 und 18. Bei weiterer Verschiebung werden, wie in Fig. 2 erkennbar ist, die Kontaktnasen 19 abgebogen, wobei sie zunächst in Kontakt mit dem Überbrückungsleiter 17 bleiben. In einer Anfangsphase der Ankopplung steht der Zähler 3 also in Kontakt mit den Stromleitern, während weiterhin eine Überbrückung durch das Kontaktelement 17 gegeben ist. Diese Phase kann der Funktionskontrolle des Stromzählers dienen, in welcher er unter (geringer) Spannung steht, der Strom durch den Überbrückungsleiter 17 aber noch fließt. So kann der Stromfluss nicht durch einen defekten Stromzähler unterbrochen werden.

In der Endstellung der Verschiebung sind die Kontaktnasen 19 von dem Überbrückungsleiter 17 abgehoben. Strom fließt nun nur noch über den Stromzähler 3.

In dieser Endstellung kann der Stromzähler 3 durch das Steckschloss 22, dessen Öffnung allein dem Stromversorgungsbetrieb vorbehalten ist, gegen Rückverschiebung gesichert werden. Zusätzlich könnte noch eine Plombierung erfolgen.

Mit Hilfe über das Steckverbindungselement 20 zugeführter Signalleitungen können z.B. Ferneinstellungen oder/und -auslesungen des Zählers 3 durch den Stromversorgungsbetrieb erfolgen.

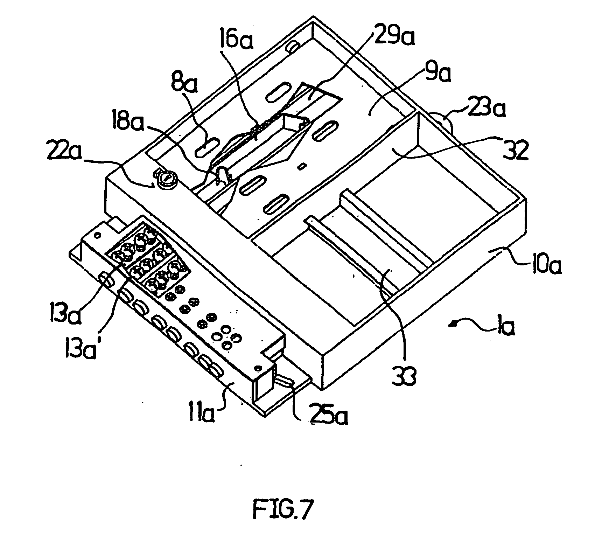

Es wird nun auf das Beispiel von Fig. 7 Bezug genommen, wo gleiche oder gleichwirkende Teile mit derselben Bezugszahl wie in den vorangehenden Figuren bezeichnet sind, wobei der betreffenden Bezugszahl jeweils der Buchstabe a beigefügt ist.

Das Ausführungsbeispiel von Fig. 7 unterscheidet sich von dem vorangehenden Beispiel dadurch, dass ein nach einer Seite erweiterter Kastenteil 10a vorgesehen ist, wobei in der durch eine Trennwand 32 abgetrennten Erweiterung eine Hutschiene 33 für die Aufnahme von Geräten, z.B. Steuergeräten, die mit dem elektronischen Stromzähler zusammenarbeiten, vorgesehen ist. Eine Abdeckung für die Erweiterung ist nicht gezeigt.

In dem gezeigten Beispiel verteilen sich Schraubklemmanschlusselemente 13a und 13a' im wesentlichen über die gesamte Länge einer mit dem Kastenteil 10a verbundenen Anschlussleiste 11a. Entsprechend sind Federkontaktelemente 16a und 18a mit unterschiedlich langen Abwinklungen (nicht gezeigt) an ihren der Anschlussleiste 11a zugewandten Enden erforderlich, um eine Verbindung zu den Schraubklemmanschlusselementen 13a,13a' herstellen zu können. Im übrigen können die Schraubklemmanschlusselemente zueinander in einem Normabstand angeordnet sein.

Abweichend von dem gezeigten Beispiel könnten Schraubklemmanschlusselemente auch nur über diejenige Länge der Anschlussleiste 11a verteilt sein, welche der Breite des Stromzählers entspricht.

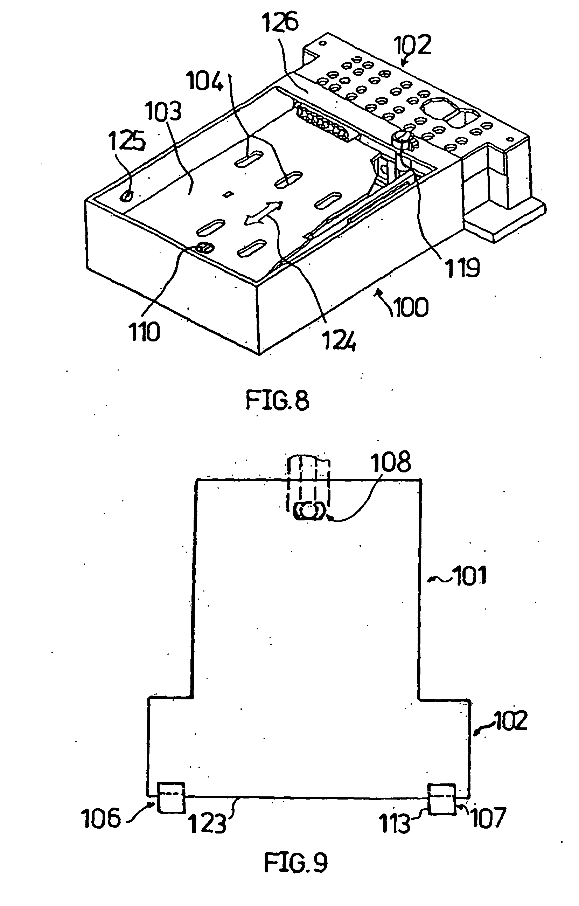

Im folgenden wird auf die Figuren 8 bis 14 Bezug genommen.

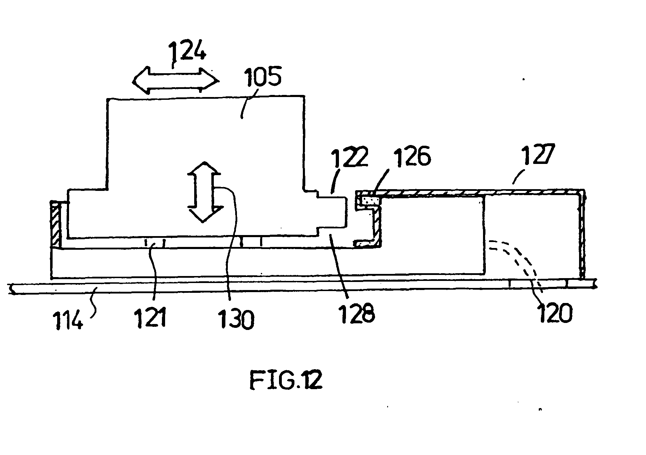

Ein dem Adapter von Fig. 1 ähnlicher Stromzähleradapter 100 mit einem Kunststoffgehäuse weist einen Kastenteil 101 und einen Klemmleistenteil 102 für den Anschluss von Stromleitern auf. Der Kastenteil 101 ist mit einem Zwischenboden 103 für die Aufnahme eines Stromzählers 105 gemäß Pfeil 130 (Fig. 12) versehen, wobei in dem Zwischenboden Öffnungen 104 für den Durchtritt von der Bodenfläche des Stromzählergehäuses vorstehender Kontaktelemente 121 gebildet sind. Unter dem Zwischenboden befinden sich Einrichtungen zum Anschluss der Kontaktelemente mit Leitern, welche zu dem Klemmleistenteil 102 geführt sind. Der Stromzähler 105 lässt sich auf dem Zwischenboden 103 gemäß Pfeil 124 hin- und herschieben, wobei er in einer durch einen Bolzen bei 119 arretierbaren Verschiebungsposition durch Zapfen 125 und einen Steg 126 formschlüssig am Zwischenboden 103 gehalten ist.

Auf seiner dem Stromzähler 105 abgewandten Seite weist der Stromzähleradapter Hakenelemente 106 bis 108 auf, wovon die Hakenelemente 106 und 107 einstückig an das Adaptergehäuse und das hammerartig ausgebildete Hakenelement 108 an einen Drehbolzen 109 angeformt sind. Ein mit einem Eingriffsschlitz für einen Schraubendreher versehener Kopf 110 des Drehbolzens 109 lässt sich gegen eine einstückig an das Gehäuse angeformte Hülse 111 anlegen, die sich in das Gehäuse hinein nach innen von einer Bodenwand 112 erstreckt. Abweichend hiervon ließe sich das Adaptergehäuse ohne Bodenwand ausbilden und am Zwischenboden ein Ansatz mit einer Einsenkung für die Aufnahme des Bolzenkopfes versehen.

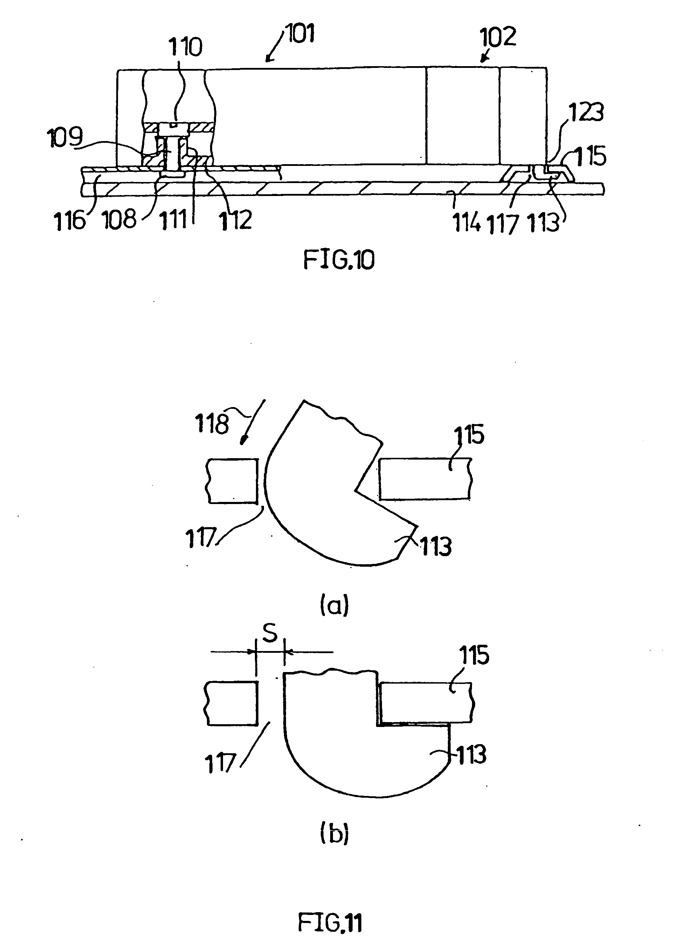

Wie aus den Fig. 9 und 10 hervorgeht, sind die Hakenelemente 106 und 107 nahe einer Randkante 123 des Adaptergehäuse angeordnet, wobei ein zur Bodenwand 112 paralleler Hakenschenkel 113 jeweils über die Randkante hinaus vorsteht. Der Hakenschenkel könnte auch zur Randkante bündig sein oder zurückstehen. Zweckmäßig wird dann die Randkante abgeschrägt.

Zur Befestigung des Adapters an einer in einem Zählerschrank oder -kasten vorgesehenen Trägerplattform bzw. Zählertragplatte 114 (Fig. 10), werden die Hakenelemente 106 und 107 in einen Schlitz 117 einer Halteschiene 115 eingehängt. Bei der Halteschiene 115 handelt es sich um die horizontale Halteschiene eines Zählerkreuzes, das eine weitere, vertikal angeordnete Halteschiene 116 mit einem entsprechenden Schlitz aufweist.

Wie aus Fig. 11a hervorgeht, erfolgt das Einhängen im Zuge einer Kippbewegung, bei welcher der Adapter gemäß Pfeil 118 in Richtung zu der Zählertragplatte 114 verschwenkt wird. Diese Art der Einhängung erlaubt es, die Hakenelemente 106, 107 im Verhältnis zur Breite des Schlitzes 117 so zu bemessen, dass der nach Einhängung mögliche, möglichst kleine Verschiebungsweg S parallel zur Zählertragplatte 114 kleiner als die Länge des Hakenschenkels 113 ist, so dass sich die Hakenelemente 106, 107 durch entsprechende Verschiebung des Adapters nicht aus der Verhakung lösen lassen.

Bei Drehung des Bolzens 109 hintergreift das Hakenelement 108 die vertikale Halteschiene 116 auf beiden Seiten ihres Schlitzes und verhindert eine die Elemente 106 und 107 aus ihrer Verhakung lösende Kippbewegung des Adapters.

Der auf den Zwischenboden 109 aufgesetzte und am Adapter durch einen verplombten Bolzen gegen Verschiebung parallel zum Zwischenboden gesicherte Stromzähler 105 versperrt den Zugang zum Drehbolzen 109, so dass sich die Befestigung des Adapters an der Zählertragplatte 114 unbefugterweise nicht lösen lässt.

Es wird nun auf Fig. 12 Bezug genommen, wo mit der Bezugszahl 127 eine Leistenabdeckhaube bezeichnet ist, welche neben dem Klemmleistenteil 102 an den Klemmleistenteil 102 angeschlossene, durch eine Öffnung 120 in der Zählertragplatte 114 verlegte Anschlussleitungen abdeckt.

Der gemäß Pfeil 124 in seine Ankopplungsstellung verschobene Stromzähler 105 hält die Leistenabdeckhaube 127 formschlüssig zwischen sich und dem Adapter fest, wobei die Abdeckhaube 127 um den Steg 126 herumgeführt ist und in Stufenausnehmungen 122 und 128 am Zählergehäuse eingreift. Es wäre denkbar, die Abdeckhaube an ihrem dem Stromzähler 105 abgewandten Ende an der Zählertragplatte zu befestigen, etwa durch eine in einen Schlitz in der Zählertragplatte angreifendes Hakenelement.

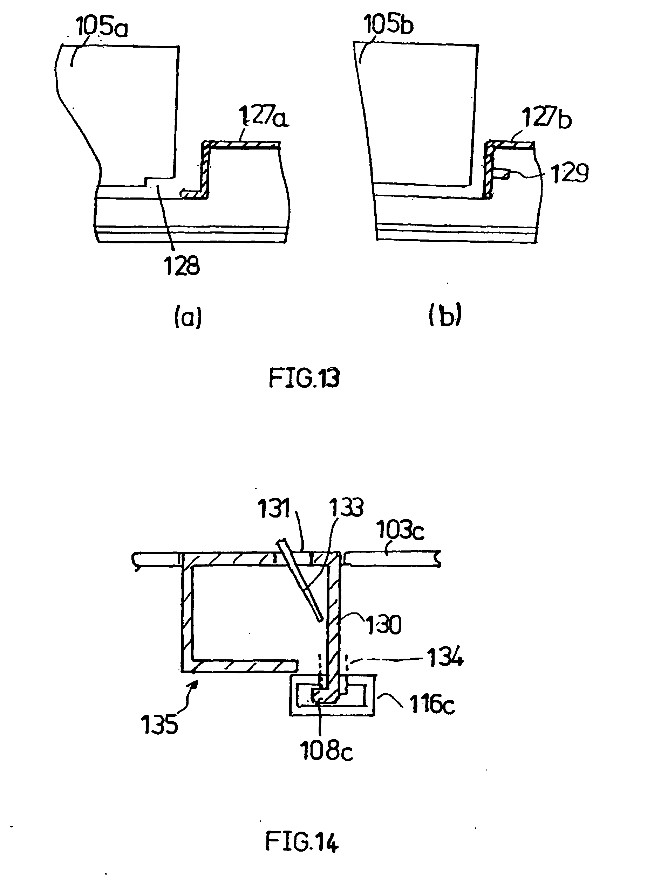

Fig. 13 zeigt weitere Beispiele für die formschlüssige Halterung einer Leistenabdeckhaube. Bei dem Ausführungsbeispiel von Fig. 13a fehlt der Steg 126. Entsprechend ist eine Abdeckhaube 127a nur zweimal abgewinkelt und ein Gehäuse eines Zählers 105a weist nur eine einzige Ausnehmung 128a auf.

Bei dem Beispiel von Fig. 13b ist eine Abdeckhaube 127b nur einfach abgewinkelt und mit einem in das Adaptergehäuse eingeführten Haltestift 129 versehen.

Umgekehrt könnte die Abdeckhaube den Stromzähler formschlüssig halten und Abdeckhaube und Stromzähler durch einen einzigen Bolzen gegen Verschiebung parallel zur Zählertragplatte gesichert sein.

Fig. 14 zeigt ein anstelle des Drehbolzens 109 verwendbares rahmenartiges Verbindungselement 135, das in einem Zwischenboden 103c versenkbar ist und einen elastischen Schenkel 130 mit einem Hakenelement 108c aufweist, das in eine Zählerkreuzhalteschiene 116c einrastbar ist. Durch eine Öffnung 131 in einem der Rahmenschenkel hindurch lässt sich durch ein Werkzeug 133 führen und die Verhakungsverbindung mit der Schiene lösen. Zur Vermeidung einer Hin- und Herbeweglichkeit kann in die Halteschiene 116c ein, z.B. mit dem Adaptergehäuse verbundener Bolzen 134 eingreifen, dessen Breite gleich der Schlitzbreite des Schlitzes in der Halteschiene 116c ist.

## Patentansprüche

1. Anschlussvorrichtung für einen elektronischen Stromzähler (3;105), mit einer mit installierten Stromkabeln verbundenen, z.B. durch einen Zählerkasten (2) gebildeten, Trägerplattform, die ein Zählerkreuz (5,6;115,116) aufweist und zur Aufnahme eines von dem elektronischen Stromzähler (3) verschiedenen, direkt an das Zählerkreuz (5,6;115,116) gekoppelten Stromzähler vorgesehen ist, mit einem Adapter (1a), der Einrichtungen zur Ankopplung des Adapters an das Zählerkreuz (5,6;115,116) sowie Einrichtungen zur Ankopplung des elektronischen Stromzählers (3;105) an den Adapter (1a) umfasst und wobei eine Abdeckhaube (127) vorgesehen ist und
der Adapter (1a) einen Kastenteil (10; 101) mit einem den elektronischen Stromzähler (3;105) aufnehmenden Zwischenboden (9;103) aufweist, in dem Langlöcher (8;104) für den Durchtritt von dem elektronischen Stromzähler vor stehender Kontaktstifte (7;121) gebildet sind,
- der elektronische Stromzähler (3;105) an den Adapter (1a) unter paralleler Verschiebung auf dem Zwischenboden und unter automatischer Kontaktierung in dem Kastenteil (10;101) angeordneter Stromleiter (16,18) durch die Kontaktelemente (7;121) koppelbar ist,
- der Adapter (1a) eine Anschlussleiste (11;102) mit Schraubklemmanschlusselementen (13) umfasst, die mit den Stromleitern (16,18) verbunden und mit den installierten Stromkabeln verbindbar sind, und die Abdeckhaube (127) die Anschlussleiste (102) und an die Anschlussleiste (102) durch Öffnungen (120) in der Trägerplattform (114) an die Anschlussleiste (102) geführte Leitungen abdeckt, wobei die Abdeckhaube (127) formschlüssig zwischen dem Adapter und dem an den Adapter gekoppelten Stromzähler (105) und der Stromzähler (105) formschlüssig zwischen der Abdeckhaube (127) und dem Adapter festgehalten wird.

2. Vorrichtung nach Anspruch 1,
**dadurch gekennzeichnet,**
**dass** sich der Stromzähler (3;105) an dem Adapter (1a) ohne Werkzeugeinsatz über eine Schnellkupplung, vorzugsweise durch Formschluss, befestigen lässt.

3. Vorrichtung nach Anspruch 1 oder 2,
**dadurch gekennzeichnet,**
**dass** die Stromleiter Federkontaktelemente (16,18) mit einer gegen einen Überbrückungsleiter (17) anliegenden Kontaktnase (19) aufweisen, wobei die Kontaktnase (19) durch ein von dem Gehäuse des Stromzählers (3) vorstehendes Kontaktelement (7) bei der Ankopplung des Stromzählers durch Abbiegung von dem Überbrückungsleiter (17) trennbar ist.

4. Vorrichtung nach Anspruch 3,
**dadurch gekennzeichnet,**
**dass** die durch das Kontaktelement (7) abgebogene Kontaktnase (19) in einer ersten Phase der Ankopplung mit dem Überbrückungsleiter (17) elektrisch verbunden bleibt.

5. Vorrichtung nach einem der Ansprüche 1 bis 4.
**dadurch gekennzeichnet,**
**dass** die Einrichtungen zur Anbringung zusätzlicher Geräte eine sich parallel zu einer Erweiterung des Zwischenbodens (9a) erstreckende Hutschiene (33) umfassten.

6. Vorrichtung nach einem der Ansprüche 1 bis 5.
**dadurch gekennzeichnet,**
**dass** Einrichtungen (109,110) zur Lösung der Verbindung des Adapters (1a) von der Zählertragplatte durch den an den Adapter angekoppelten elektronischen Stromzähler (105) blockiert sind.

7. Stromzähleradapter nach Anspruch 6,
**dadurch gekennzeichnet,**
**dass** die Einrichtungen zur Lösung der Verbindung von Adapter und Zöhlerfragplatte (114) einen, insbesondere durch ein Werkzeug drehbaren, Kopf (110) eines Verbindungselements (106, 109, 110) umfassen, welcher durch den angekoppelten Stromzähler (105) abgedeckt ist.

8. Stromzähleradapter nach Anspruch 7,
**dadurch gekennzeichnet,**
**dass** zur Verbindung des Adapters mit der Zählertragplatte (114) Hakenelemente (106-108) auf der der Zählertragplatte (114) zugewandten Seite des Adapters gebildet sind.

9. Stromzähleradapter nach Anspruch 8,
**dadurch gekennzeichnet,**
**dass** wenigstens eines der Hakenelemente (106-108) im Schlitz einer der Halteschienen des Zählerkreuzes (115, 116) einhakbar ist.

10. Stromzähleradapter nach Anspruch 8 oder 9,
**dadurch gekennzeichnet,**
**dass** wenigstens eines (106, 107) der Hakenelemente (106-108) im Zuge einer Kippbewegung des Adapters in ein, vorzugsweise durch eine der Halteschienen des Zählerkreuzes (115, 116) gebildetes, Hakenwiderlager einhängbar ist.

11. Stromzöhleradopter nach Anspruch 10,
**dadurch gekennzeichnet,**
**dass** das wenigstens eine Hakenelement (106,107) am Rand einer der Zöhlertragplatte (114) zugewandten Fläche des Adapters angeordnet ist, wobei ein zu der Fläche paralleler Hakenschenkel (113) des Hakenelements (106, 107) zu dem Rand hin gerichtet ist.

12. Stromzähleradapter nach Anspruch 11,
**dadurch gekennzeichnet,**
**dass** der Hakenschenkel (113) über den Rand hinaus vorsteht.

13. Stromzähleradapter nach einem der Ansprüche 7 bis 12,
**dadurch gekennzeichnet,**
**dass** wenigstens eines (108) der Hakenelemente (106-108) an einem den Drehkopf (110) aufweisenden Drehbolzen (109) gebildet ist.

14. Stromzähleradapter nach Anspruch 13,
**dadurch gekennzeichnet,**
**dass** das wenigstens eine Hakenelement (108) im Schlitz der vertikalen Halteschiene (116) des Zählerkreuzes (115, 116) einhakbar ist.

15. Stromzähleradapter nach einem der Ansprüche 7 bis 14,
**dadurch gekennzeichnet,**
**dass** ein in einem den Stromzähler aufnehmenden Zwischenboden (103b) versenkbares Verbindungselement (135) vorgesehen ist, das einen elastischen Hakenschenkel (130) aufweist und im Zwischenboden eine Öffnung (132) für die Durchführung eines die Verhakung lösenden Werkzeugs (133) gebildet ist.

16. Stromzähleradapter nach Anspruch 15,
**dadurch gekennzeichnet,**
**dass** zusätzlich zu dem Hakenschenkel (130) in eine hinterschnittene Verhakungsrille ein Bolzen (134) eingreift, dessen Durchmesser gleich der Breite der Verhakungsrille ist.

17. Adapter für eine Anschlussvorrichtung nach einem der Ansprüche 1 bis 16, wobei der Adapter (1a) Einrichtungen zur Ankopplung des Adapters an ein Zählerkreuz (5,6;115,116) Trägerplattform sowie Einrichtungen zur Ankopplung eines elektronischen Stromzählers (3;105) an den Adapter (1a) und eine Abdeckhaube (119) aufweist,
wobei
der Adapter (1a) einen Kastenteil (10;101) mit einem den elektronischen Stromzähler (3;105) aufnehmenden Zwischenboden (9;103) aufweist, in dem Langlöcher für den Durchtritt von dem elektronischen Stromzähler vorstehender Kontaktstifte (7;121) gebildet sind,
- der elektronische Stromzähler (3;105) an den Adapter (1a) unter paralleler Verschiebung auf dem Zwischenboden und unter automatischer Kontaktierung in dem Kastenteil (10;101) angeordneter Stromleiter (16,18) durch die Kontaktelemente (7;21) koppelbar ist
- der Adapter (1a) eine Anschlussleiste (11;102) mit Schraubklemmanschlusselementen (13) umfasst, die mit den Stromleitern (16,18) verbunden und mit installierten, an die Zählerplatzbaugruppe (2) anschließbaren Stromkabeln verbindbar sind, und die Abdeckhaube (127) die Anschlussleiste (102) und an die Anschlussleiste (102) durch Öffnungen (120) in der Trägerplattform (114) an die Anschlussleiste (102) geführte Leitungen abdeckt, wobei die Abdeckhaube (127) formschlüssig zwischen dem Adapter und dem an den Adapter gekoppelten Stromzähler (105) und der Stromzähler (105) formschlüssig zwischen der Abdeckhaube (127) und dem Adapter festgehalten wird.

## Claims

1. Connection apparatus for an electronic electricity meter (3; 105), having a carrier platform which is connected to installed power cables, for example formed by a meter box (2), and has a meter support (5, 6; 115, 116) and is provided to accommodate an electricity meter which differs from the electronic electricity meter (3) and is coupled directly to the meter support (5, 6; 115, 116), having an adapter (1a) which comprises devices for coupling the adapter to the meter support (5, 6; 115, 116) and also devices for coupling the electronic electricity meter (3; 105) to the adapter (1a), and wherein a covering hood (127) is provided,
and
- the adapter (1a) has a box part (10; 101) with an intermediate base (9; 103) which accommodates the electronic electricity meter (3; 105) and in which elongated holes (8; 104) are formed for the passage of contact pins (7; 121) which project from the electronic electricity meter,
- the electronic electricity meter (3; 105) can be coupled to the adapter (1a) by the contact elements (7; 121) with parallel displacement toward the intermediate base and automatic contact-connection to power conductors (16, 18) which are arranged in the box part (10; 101),
- the adapter (1a) comprises a connection strip (11; 102) with screw terminal connection elements (13) which are connected to the power conductors (16, 18) and can be connected to the installed power cables, and the covering hood (127) covers the connection strip (102) and lines which are routed to the connection strip (102) through openings (120) in the support platform (144) on the connection strip (102), wherein the covering hood (127) is firmly held in an interlocking manner between the adapter and the electricity meter (105), which is coupled to the adapter, and the electricity meter (105) is firmly held in an interlocking manner between the covering hood (127) and the adapter.

2. Apparatus according to Claim 1,
**characterized**
**in that** the electricity meter (3; 105) can be fastened to the adapter (1a) without the use of tools by means of a quick-action coupling, preferably by way of an interlocking connection.

3. Apparatus according to Claim 1 or 2,
**characterized**
**in that** the power conductors have spring contact elements (16, 18) with a contact lug (19) which rests against a bridging conductor (17), wherein the contact lug (19) can be separated by a contact element (7) which projects from the housing of the electricity meter (3), when the electricity meter is coupled, by being bent away from the bridging conductor (17).

4. Apparatus according to Claim 3,
**characterized**
**in that** the contact lug (19) which is bent away by the contact element (7) remains electrically connected to the bridging conductor (17) in a first coupling phase.

5. Apparatus according to one of Claims 1 to 4,
**characterized**
**in that** the devices for attaching additional devices comprise a mounting rail (33) which extends parallel to an extension of the intermediate base (9a).

6. Apparatus according to one of Claims 1 to 5,
**characterized**
**in that** devices (109, 110) for releasing the connection between the adapter (1a) and the meter supporting plate are blocked by the electronic electricity meter (105) which is coupled to the adapter.

7. Electricity meter adapter according to Claim 6,
**characterized**
**in that** the devices for releasing the connection between the adapter and the meter supporting plate (114) comprise a head (110) of a connecting element (106, 109, 110), which head can, in particular, be rotated by a tool and is covered by the coupled electricity meter (105).

8. Electricity meter adapter according to Claim 7,
**characterized**
**in that** hook elements (106-108) are formed on that side of the adapter which faces the meter supporting plate (114) for the purpose of connecting the adapter to the meter supporting plate (114).

9. Electricity meter adapter according to Claim 8,
**characterized in that** at least one of the hook elements (106-108) can be hooked into the slot in one of the mounting rails of the meter support (115, 116).

10. Electricity meter adapter according to Claim 8 or 9,
**characterized**
**in that** at least one (106, 107) of the hook elements (106-108) can be suspended in a hook bearing, which is preferably formed by one of the mounting rails of the meter support (115, 116), during the course of a tilting movement of the adapter.

11. Electricity meter adapter according to Claim 10, **characterized in that** the at least one hook element (106, 107) is arranged on the edge of a face of the adapter which faces the meter supporting plate (114), wherein a hook limb (113) of the hook element (106, 107), which hook limb is parallel to the face, is directed toward the edge.

12. Electricity meter adapter according to Claim 11,
**characterized**
**in that** the hook limb (113) projects beyond the edge.

13. Electricity meter adapter according to one of Claims 7 to 12, **characterized in that** at least one (108) of the hook elements (106-108) is formed on a rotary bolt (109) which exhibits the rotary head (110).

14. Electricity meter adapter according to Claim 13,
**characterized**
**in that** the at least one hook element (108) can be hooked into the slot in the vertical mounting rail (116) of the meter support (115, 116).

15. Electricity meter adapter according to one of Claims 7 to 14,
**characterized**
**in that** a connecting element (135) which can be countersunk in an intermediate base (103b) which accommodates the electricity meter is provided, said connecting element having an elastic hook limb (130), and an opening (132) for the passage of a tool (133) which releases the hook arrangement being formed in the intermediate base.

16. Electricity meter adapter according to Claim 15,
**characterized**
**in that**, in addition to the hook limb (130), a bolt (134) engages in an undercut hook-engagement groove, the diameter of said bolt being equal to the width of the hook-engagement groove.

17. Adapter for a connection apparatus according to one of Claims 1 to 16, wherein the adapter (1a) has devices for coupling the adapter to a meter support (5, 6; 115, 116) of a support platform, and also devices for coupling an electronic electricity meter (3; 105) to the adapter (1a), and a covering hood (127), wherein
- the adapter (1a) has a box part (10; 101) with an intermediate base (9; 103) which accommodates the electronic electricity meter (3; 105) and in which elongate holes are formed for the passage of contact pins (7; 121) which project from the electronic electricity meter,
- the electronic electricity meter (3; 105) can be coupled to the adapter (1a) by the contact elements (7; 21) with parallel displacement toward the intermediate base and automatic contact-connection to power conductors (16, 18) which are arranged in the box part (10; 101),
- the adapter (1a) comprises a connection strip (11; 102) with screw terminal connection elements (13) which are connected to the power conductors (16, 18) and can be connected to installed power cables which can be connected to the meter station assembly (2), and the covering hood (127) covers the connection strip (102) and lines which are routed to the connection strip (102) through openings (120) in the support platform (144) on the connection strip (102), wherein the covering hood (127) is firmly held in an interlocking manner between the adapter and the electricity meter (105) which is coupled to the adapter, and the electricity meter (105) is firmly held in an interlocking manner between the covering hood (127) and the adapter.

## Revendications

1. Dispositif de branchement pour un compteur électrique électronique (3 ; 105), comprenant une plate-forme porteuse reliée à des câbles électriques installés et formée par exemple par un boîtier de compteur (2), qui comprend un rail de support (5,6 ; 115, 116) et qui est prévue pour recevoir un compteur électrique différent du compteur électrique électronique (3) et couplé directement au rail de support (5, 6 ; 115, 116), comprenant un adaptateur (1a) qui inclut des moyens pour accoupler l'adaptateur au rail de support (5, 6 ; 115, 116) ainsi que des moyens pour l'accouplement du compteur électrique électronique (3 ; 105) à l'adaptateur (1a), et dans lequel il est prévu un capot de recouvrement (127), et
- l'adaptateur (1a) comprend une partie en caisson (10;101) avec un fond intermédiaire (9 ; 103) qui reçoit le compteur électrique électronique (3 ; 105) et dans lequel sont formés des trous oblongs (8 ; 104) pour la traversée de broches de contact (7 ; 121) qui dépassent du compteur électrique électronique,
- le compteur électrique électronique (3 ; 105) peut être accouplé à l'adaptateur (1a) au moyen des éléments de contact (7 ; 121) avec translation parallèle sur le fond intermédiaire et avec mise en contact automatique des lignes électriques (16, 18) agencées dans la partie en caisson (10; 101),
- l'adaptateur (1a) comprend une barrette de raccordement (11 ;102) avec des éléments de raccordement (13) serrés/vissés, qui sont reliés aux lignes électriques (16, 18) et peuvent être reliés aux câbles électriques installés, et le capot de recouvrement (127) recouvre la barrette de raccordement (102) et les lignes amenées à la barrette de raccordement (102) via des ouvertures (120) dans la plate-forme porteuse (114), dans lequel le capot de recouvrement (127) est immobilisé en coopération de formes entre l'adaptateur et le compteur électrique (105) accouplé à l'adaptateur, et le compteur électrique (105) est immobilisé en coopération de formes entre le capot de recouvrement (127) et l'adaptateur.

2. Dispositif selon la revendication 1,
**caractérisé en ce que** le compteur électrique (3 ; 105) peut être fixé sur l'adaptateur (1a) sans utilisation d'outils via un accouplement rapide, de préférence par coopération de formes.

3. Dispositif selon la revendication 1 ou 2,
**caractérisé en ce que** les lignes électriques comprennent des éléments de contact à effet ressort (16, 18) avec un ergot de contact (19) appliqué contre une ligne de court-circuit (17), ledit ergot de contact (19) pouvant être séparé par flexion de la ligne de court-circuit (17) lors de l'accouplement du compteur électrique au moyen d'un élément de contact (7) qui dépasse du boîtier du compteur électrique (3).

4. Dispositif selon la revendication 3,
**caractérisé en ce que** l'ergot de contact (19) fléchi par l'élément de contact (7) reste électriquement connecté à la ligne de court-circuit (17) dans une première phase de l'accouplement.

5. Dispositif selon l'une des revendications 1 à 4,
**caractérisé en ce que** les moyens destinés au montage d'appareils additionnels comprennent un rail en chapeau (33) qui s'étend parallèlement à un élargissement du fond intermédiaire (9a).

6. Dispositif selon l'une des revendications 1 à 5,
**caractérisé en ce que** des moyens (109, 110) pour détacher la liaison de l'adaptateur (1a) depuis la plaque porteuse de compteur sont bloqués par le compteur électrique électronique (105) accouplé à l'adaptateur.

7. Adaptateur de compteur électrique selon la revendication 6,
**caractérisé en ce que** les moyens pour détacher la liaison de l'adaptateur et de la plaque porteuse de compteur (114) comprennent une tête (110), en particulier à faire tourner au moyen d'un outil, d'un élément de liaison (106, 109, 110), lequel est recouvert par le compteur électrique (105) accouplé.

8. Adaptateur de compteur électrique selon la revendication 7,
**caractérisé en ce que** pour la jonction de l'adaptateur avec la plaque porteuse de compteur (114), des éléments en crochet (106-108) sont formés sur le côté de l'adaptateur tourné vers la plaque porteuse de compteur (114).

9. Adaptateur de compteur électrique selon la revendication 8,
**caractérisé en ce que** l'un au moins des éléments en crochet (106-108) peut être accroché dans la fente de l'un des rails de maintien du rail de support (115, 116).

10. Adaptateur de compteur électrique selon la revendication 8 ou 9,
**caractérisé en ce que** l'un au moins (106, 107) des éléments en crochet (106-108) est susceptible d'être accroché, au cours d'un mouvement de basculement de l'adaptateur, dans un moyen d'accrochage antagoniste, formé de préférence par l'un des rails de maintien du rail de support (115, 116).

11. Adaptateur de compteur électrique selon la revendication 10,
**caractérisé en ce que** ledit au moins un élément en crochet (106, 107) est agencé à la bordure d'une surface de l'adaptateur, tournée vers la plaque porteuse de compteur (114), un bras (113), parallèle à la surface, de l'élément en crochet (106, 107) étant dirigé vers la bordure.

12. Adaptateur de compteur électrique selon la revendication 11,
**caractérisé en ce que** le bras (113) du crochet dépasse au-delà de la bordure.

13. Adaptateur de compteur électrique selon l'une des revendications 7 à 12,
**caractérisé en ce que** l'un au moins (108) des éléments en crochet (106-108) est formé sur un goujon rotatif (109) qui comporte la tête rotative (110).

14. Adaptateur de compteur électrique selon la revendication 13,
**caractérisé en ce que** ledit au moins un élément en crochet (108) est susceptible d'être accroché dans la fente du rail de maintien (116) vertical du rail de support (115, 116).

15. Adaptateur de compteur électrique selon l'une des revendications 7 à 14,
**caractérisé en ce qu'**il est prévu un élément de liaison (135) susceptible d'être enfoncé dans un fond intermédiaire (103b) qui reçoit le compteur électrique, élément qui comprend un bras de crochet élastique (130), et une ouverture (132) est formée dans le fond intermédiaire pour la traversée d'un outil (133) qui annule l'accrochage.

16. Adaptateur de compteur électrique selon la revendication 15,
**caractérisé en ce que**, en supplément au bras (130) de crochet, un goujon (134) s'engage dans une rainure d'accrochage en contre-dépouille, dont le diamètre est égal à la largeur de la rainure d'accrochage.

17. Adaptateur pour un dispositif de branchement selon l'une des revendications 1 à 6,
dans lequel l'adaptateur (1a) comprend des moyens pour l'accouplement de l'adaptateur à un rail de support (5, 6 ; 115, 116) d'une plate-forme porteuse, ainsi que des moyens pour l'accouplement d'un compteur électrique électronique (3 ; 105) à l'adaptateur (1a) et un capuchon de recouvrement (127), dans lequel
- l'adaptateur (1a) comprend une partie en caisson (10 ; 101) avec un fond intermédiaire (9 ; 103) qui reçoit le compteur électrique électronique (3 ; 105) et dans lequel sont formés des trous oblongs (8 ; 104) pour la traversée de broches de contact (7 ; 121) qui dépassent du compteur électrique électronique,
- le compteur électrique électronique (3 ; 105) peut être accouplé à l'adaptateur (1a) au moyen des éléments de contact (7 ; 121) avec translation parallèle sur le fond intermédiaire et avec mise en contact automatique des lignes électriques (16, 18) agencées dans la partie en caisson (10; 101),
- l'adaptateur (1a) comprend une barrette de raccordement (11; 102) avec des éléments de raccordement (13) serrés/vissés, qui sont reliés aux lignes électriques (16, 18) et peuvent être reliés aux câbles électriques installés, et le capot de recouvrement (127) recouvre la barrette de raccordement (102) et les lignes amenées à la barrette de raccordement (102) via des ouvertures (120) dans la plate-forme porteuse (114), dans lequel le capot de recouvrement (127) est immobilisé en coopération de formes entre l'adaptateur et le compteur électrique (105) accouplé à l'adaptateur, et le compteur électrique (105) est immobilisé en coopération de formes entre le capot de recouvrement (127) et l'adaptateur.
